(19) Europäisches Patentamt
European Patent Office
Office européen des brevets

(11) **EP 3 158 096 B1**

(12) **EUROPEAN PATENT SPECIFICATION**

(45) Date of publication and mention
of the grant of the patent:
**10.10.2018 Bulletin 2018/41**

(21) Application number: **15729467.9**

(22) Date of filing: **17.06.2015**

(51) Int Cl.:
**C22C 19/00** (2006.01) **C22F 1/08** (2006.01)

(86) International application number:
**PCT/EP2015/063508**

(87) International publication number:
**WO 2015/197432 (30.12.2015 Gazette 2015/52)**

(54) **COPPER BONDING WIRE WITH ANGSTROM (Å) THICK SURFACE OXIDE LAYER**

KUPFERDRAHT FÜR BINDUNGSANWENDUNGEN MIT ANGSTROEMDICKER OBERFLAECHENOXIDSCHICHT

FIL DE CONNEXION EN CUIVRE REVÊTU AVEC UNE COUCHE D'OXIDE AYANT UNE ÉPAISSEUR DE L'ORDRE D' ANGSTROEMS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.06.2014 SG 10201403532Q**

(43) Date of publication of application:
**26.04.2017 Bulletin 2017/17**

(73) Proprietor: **Heraeus Deutschland GmbH & Co. KG 63450 Hanau (DE)**

(72) Inventors:
• **SARANGAPANI, Murali**
  **Singapore 760363 (SG)**
• **ZHANG, Xi**
  **Singapore 298190 (SG)**
• **YEUNG, Ping Ha**
  **Singapore 457266 (SG)**
• **MILKE, Eugen**
  **61130 Nidderau (DE)**

(74) Representative: **Heraeus IP Heraeus Holding GmbH Schutzrechte Heraeusstraße 12-14 63450 Hanau (DE)**

(56) References cited:
**EP-A1- 2 239 766      WO-A1-2012/117636 JP-A- 2010 245 390**

• YANG B ET AL: "Stress-controlled fatigue behaviour of micro-sized polycrystalline copper wires", MATERIALS SCIENCE AND ENGINEERING A: STRUCTURAL MATERIALS: PROPERTIES, MICROSTRUCTURES AND PROCESSING, ELSEVIER BV, NL, vol. 515, no. 1-2, 25 July 2009 (2009-07-25), pages 71-78, XP026096273, ISSN: 0921-5093, DOI: 10.1016/J.MSEA.2009.02.037 [retrieved on 2009-03-04]

**Description**

The invention is related to a copper wire having an only 0.5 to < 6 nm thin circumferential surface layer of copper oxide.

The use of bonding wires in electronics and microelectronics applications is well-known state of the art. While bonding wires were made from gold in the beginning, nowadays less expensive materials are used such as copper. The fatigue behaviour of copper wires for bonding applications has been investigated in the scientific paper B. YANG et al.: "Stress-controlled fatigue behaviour of micro-sized polycrystalline copper wires", MATERIAL SCIENCE AND ENGINEERING A: STRUCTURAL MATERIALS: PROPERTIES, MICROSTRUCTURES AND PROCESSING, ELSEVIER BV, NL, vol. 515, no. 1-2, 25 July 2009, pages 71-78, XP026096273. While copper wire provides very good electric and thermal conductivity, bonding of copper wire has its challenges. Moreover, copper wires are susceptible to oxidation of the wire.

There have been various approaches to prevent copper bonding wires from surface oxidation. Examples include coating the copper wire with a coating of an oxidation-resistant noble metal, a glass coating or a polymer coating.

Uncoated copper wires for wire bonding applications typically have a surface layer of copper oxide, the layer thickness whereof typically lying in the range of, for example, 6 to 20 nm.

The term "copper oxide" is used herein. It shall mean CuO and/or $Cu_2O$.

As a result of extensive R&D effort the applicant has developed a copper wire having a diameter of 10 to 80 $\mu$m, preferably 15 to 50 $\mu$m and a 0.5 to < 6 nm, preferably 0.5 to 4 nm, in particular 0.5 to 3.5 nm thin circumferential surface layer of copper oxide. The copper wire bulk material is either $\geq$ 99.99 wt.-% (weight-%) pure copper or a copper alloy consisting of 10 to 1000 wt.-ppm (weight-ppm), preferably 100 to 300 wt.-ppm, in particular 200 to 250 wt.-ppm of silver and/or of 0.1 to 3 wt.-%, preferably 0.5 to 2 wt.-%, in particular 1.2 to 1.3 wt.-% of palladium with copper as the remainder to make up 100 wt.-%.

The term "copper wire" is used herein. To avoid misunderstandings, it shall mean the copper wire in any form, i.e. as unprocessed copper wire and as processed, i.e. ball- or wedge-bonded copper wire.

The term "0.5 to < 6 nm thin circumferential surface layer of copper oxide" is used herein. It shall mean that the 0.5 to < 6 nm thin circumferential surface layer of copper oxide is copper oxide or that it comprises copper oxide. In other words, the 0.5 to < 6 nm thin circumferential surface layer of copper oxide may consist of copper oxide or it may comprise copper oxide in a concentration lying in the range of, for example, 50 to 100 wt.-%. In an embodiment, it exhibits a concentration gradient of copper oxide over the depth of said 0.5 to < 6 nm in perpendicular direction from the outer wire surface to the center of the wire. Such copper oxide concentration may be high at the outer wire surface, for example, 90 to 100 wt.-% of copper oxide and it diminishes rapidly down to 0 wt.-% over said depth.

In the following, the "copper alloy consisting of 10 to 1000 wt.-ppm of silver and/or of 0.1 to 3 wt.-% of palladium with copper as the remainder to make up 100 wt.-%" is also called "copper alloy" for short.

The phrase "copper as the remainder to make up 100 wt.-%" is used herein. It shall mean that copper is the main component in the copper alloy. To avoid misunderstandings, this shall not be understood to exclude other elements which are not expressly named and which due to prevailing technical conditions may have found their way into the copper alloy, for example, as a consequence of an unintentional but inevitable incorporation during manufacture. In other words, such other elements may be present in the alloy as inevitable impurities, however only in a very minor total amount of, for example, > 0 to 100 wt.-ppm. In any case such inevitable impurities are not deliberately added or introduced into the copper alloy forming composition. Insofar, the phrase "copper as the remainder to make up 100 wt.-%" means that the wt.-% proportion which is missing to make up 100 wt.-% of the copper alloy consists of copper plus said inevitable impurities, if the latter are present.

The copper alloy can be prepared by conventional processes known to the person skilled in the art of metal alloys, for example, by melting together the copper and the silver and/or palladium in the desired ratio. In doing so, it is possible to make use of conventional copper-silver or copper-palladium master alloys. The melting process can for example be performed making use of an induction furnace and it is expedient to work under vacuum or under an inert gas atmosphere. The materials used can have a purity grade of, for example, 99.99 wt.-% and above. The copper alloy melt is typically cast in a mold of room temperature in which it cools down and solidifies.

The nature and the thickness of a copper or copper alloy wire's surface layer of copper oxide can be determined or characterized by time of flight-secondary ion mass spectrometry (ToF-SIMS; with use of bismuth ion to analyze the molecules in positive polarity).

The thickness of a copper or copper alloy wire's surface layer of copper oxide can also be measured by the following equivalent methods:

- Depth profiling using Ar ion sputtering in steps for period of time until 100% copper (Cu) is observed. This method is well-known to the skilled person and does not require further explanation.

- X-ray photoelectron spectroscopy (XPS) by depth profiling using standard practice. This method is well-known to the skilled person and does not require further explanation.

- Sequential electrochemical reduction analysis (SERA). For SERA the device Surface-Scan QC200 from ECI Technology can be used. ECI Technology discloses details on its website *http://www.ecitechnology.com/sites/default/files/downloads/eci-surfacescan-qc200.pdfcan*, according to which SERA can be used as a quality control tool to define the tolerances of copper wire surface oxide layer thickness. Basically, Faraday's principle is used to measure the copper oxide thickness by dissolving the copper oxide layer using borate electrolyte of about 8.5 pH. SERA is capable to analyze $Cu_2O$, $CuO$ and $Cu_2S$ on the copper wire surface similar to bulk copper. SERA records the reaction potential of $Cu_2O$, $CuO$ and $Cu_2S$ versus time. The reaction potential in the range of - 0.4 to -0.6 V, -0.8 to -0.9 V, -0.9 to -1.0 V, and -1.1 to -1.2 V corresponds to the reduction of $Cu_2O$, $CuO$, $Cu_2S$ and $H_2$ evolution, respectively. The time of reduction of surface oxide/sulfide is proportionate to the presence of layer thickness (T), calculated as per Faraday's equation:

$$T = \frac{M * I * t * 10^8}{n * F * S * d}$$

where, I is current in ampere, t is reduction time measured in seconds, M is molecular weight in g, F is Faraday's constant (96498 coulombs), n is number of electrons, S is surface area of immersed copper section in cm$^2$ and d is density of film in g/cm$^3$.

The SERA method is applicant's preferred method for measuring the layer thickness of a copper or copper alloy wire's surface layer of copper oxide.

In a particular embodiment, the copper wire of the invention exhibits free carbon (elemental carbon) at its surface i.e. on top of the surface layer of copper oxide and/or as a concentration gradient of free carbon over a depth of, for example, 0.6 to 5 nm in perpendicular direction from the outer wire surface to the center of the wire. Such free carbon concentration may be high at the outer wire surface, for example, 90 to < 100 wt.-% of free carbon and it diminishes rapidly down to 0 wt.-% over said depth. The concentration gradient of free carbon may overlap with the afore mentioned concentration gradient of copper oxide.

The depth of said free carbon gradient can be determined or characterized by ToF-SIMS (with Bismuth ion to analyze the molecules in positive polarity) or by XPS by depth profiling using standard practice.

The invention is also related to a process for the manufacture of the copper wire of the invention. The copper wire of the invention can be made by a process comprising the steps:

(a) providing a copper precursor of ≥ 99.99 wt.-% pure copper or of the copper alloy,
(b) drawing the precursor until a final diameter of 10 to 80 $\mu$m, preferably 15 to 50 $\mu$m of the wire is reached;
(c) annealing the drawn wire at an object temperature (peak temperature) of 580 to 750 °C for 0.2 to 0.4 seconds in a 90 to 96 vol.-% (volume-%) inert gas : 4 to 10 to vol.-% hydrogen atmosphere, and
(d) quenching the annealed wire in water,

wherein the vol.-% total 100 vol.-%.

In step (a) of the process of the invention a copper precursor of ≥ 99.99 wt.-% pure copper or of the copper alloy is provided.

Typically, such copper precursor is in the form of a rod having a diameter of, for example, 2 to 25 mm and a length of, for example, 5 to 100 m. Such rod can be made analogously or in accordance with the afore disclosed process for the preparation of the copper alloy, i.e. by casting the copper or copper alloy melt in an appropriate mold of room temperature, followed by cooling and solidifying.

In step (b) of the process of the invention the copper precursor is drawn in several steps until a final diameter of 10 to 80 $\mu$m, preferably 15 to 50 $\mu$m of the wire is reached. Such wire drawing process is well known to the person skilled in the art. Conventional tungsten and diamond drawing dies may be employed and conventional drawing lubricants may be employed to support the drawing. Typically, the copper wire obtained after completion of step (b) has a circumferential surface layer of copper oxide with a layer thickness in the range of, for example, 6 to 20 nm.

In step (c) of the process of the invention the drawn wire is annealed (finally annealed, strand annealed) at an object temperature of 570 to 750 °C for 0.2 to 0.4 seconds in a 90 to 96 vol.-% inert gas : 4 to 10 vol.-% hydrogen atmosphere, wherein the vol.-% total 100 vol.-%.

In case of a ≥ 99.99 wt.-% pure copper wire it is preferred to choose an object temperature of 570 to 630 °C, while in case of a copper alloy wire the preferred object temperature is in the range of 620 to 750 °C, in particular 650 to 710 °C.

A 95 vol.-% inert gas : 5 vol.-% hydrogen atmosphere is a preferred atmosphere. The inert gas may be nitrogen and/or argon; typically, it is nitrogen.

The annealing is typically performed by pulling the wire through a conventional annealing oven, typically in the form of a cylindrical tube of a given length and with a defined temperature profile at a given speed. In so doing the annealing time/object temperature parameters can be defined and set. The annealing oven is purged with the 90 to 96 vol.-% inert gas : 4 to 10 vol.-% hydrogen mixture. Purging is preferably performed at a gas exchange rate (= gas flow rate [liter/min] : inner oven volume [liter]) lying in the range of 43 to 125 $min^{-1}$, more preferably 43 to 75 $min^{-1}$, most preferably 50 to 63 $min^{-1}$.

In step (d) of the process of the invention the annealed wire is quenched in water which, in an embodiment, may contain a surfactant, for example, 0.01 to 1 volume-% of surfactant. Quenching in water means immediately or rapidly, i.e. within 0.2 to 0.4 seconds, cooling the annealed wire from the object temperature it received in step (c) down to room temperature.

It has been found that the copper wire of the invention which is distinguished by its only 0.5 to < 6 nm thin circumferential surface layer of copper oxide is well suited for use as a bonding wire in wire bonding applications, while the copper wire of the invention in its afore mentioned particular embodiment is particularly well suited for such use.

The wire bonding technique is well known to the skilled person. In the course of wire bonding it is typical that a ball bond (1st bond) and a stitch bond (2nd bond, wedge bond) are formed. During bond forming a certain force (typically measured in grams) is applied, supported by application of ultrasonic energy (typically measured in mA). The mathematical product of the difference between the upper and the lower limits of the applied force and the difference between the upper and the lower limits of the applied ultrasonic energy in a wire bonding process defines the wire bonding process window:

$$(Upper\ limit\ of\ applied\ force - Lower\ limit\ of\ applied\ force) \cdot (Upper\ limit\ of\ ultrasonic$$
$$energy\ applied - Lower\ limit\ of\ ultrasonic\ energy\ applied) = Wire\ bonding\ process$$
$$window.$$

The wire bonding process window defines the area of force/ultrasonic energy combinations which allow formation of a wire bond that meets specifications, i.e. which passes the conventional tests like conventional pull tests, ball shear test and ball pull test to name only few.

For industrial applications it is desirable to have a wide wire bonding process window for reasons of wire bonding process robustness. The copper wire of the invention exhibits a considerably wide wire bonding process window for a copper bonding wire. For example, a copper wire of the invention 20 $\mu$m in diameter exhibits a wire bonding process window in the range of, for example, 60 to 130 mA·g for ball bonding and of, for example, 2500 to 6000 mA·g for stitch bonding.

The wire bonding results are the same irrespective of the wire diameter and wire types, i.e. ≥ 99.99 wt.-% pure copper or copper alloy. It is further believed that the only 0.5 to < 6 nm thin circumferential surface layer of copper oxide is key for the wide wire bonding process window of the copper wire of the invention. It can be said that < 6 nm of circumferential surface layer of copper oxide is a level to attain good ball and stitch bonding.

It is believed that the unique combination of the process parameters prevailing during steps (c) and (d) of the process of the invention is essential to obtain the copper wire of the invention with its considerably wide wire bonding process window. A preferred combination of said process parameters is: object temperature of 570 to 750 °C (570 to 630 °C in case of ≥ 99.99 wt.-% pure copper; 620 to 750 °C or more preferred 650 to 710 °C in case of copper alloy) for 0.2 to 0.4 seconds, use of a 95 vol.-% inert gas : 5 vol.-% hydrogen gas mixture as purging gas at a gas exchange rate in the range of 43 to 125 $min^{-1}$, more preferably 43 to 75 $min^{-1}$ and rapid cool down to room temperature within 0.2 to 0.4 seconds. An optimum was found with the following combination of process parameters: object temperature of 570 to 750 °C (570 to 630 °C in case of ≥ 99.99 wt.-% pure copper; 620 to 750 °C or more preferred 650 to 710 °C in case of copper alloy) for 0.2 to 0.4 seconds, use of a 95 vol.-% inert gas : 5 vol.-% hydrogen gas mixture as purging gas at a gas exchange rate in the range of 50 to 63 $min^{-1}$ and rapid cool down to room temperature within 0.2 to 0.4 seconds.

After completion of step (d) the copper wire of the invention is finished. In order to fully benefit from its wide wire bonding process window, it is expedient to either use it immediately for wire bonding applications, i.e. without delay, for example, within no longer than 7 days after completion of step (d). Alternatively, in order to keep the copper wire's wide wire bonding process window property and in order to prevent it from oxidative or other chemical attack, the finished copper wire is typically spooled and vacuum sealed immediately after completion of step (d), i.e. without delay, for example, within < 1 to 5 hours after completion of step (d) and then stored for further use as bonding wire. Storage in vacuum sealed condition should not exceed 6 months. After opening the vacuum seal the copper wire should be used for wire bonding within no longer than 7 days.

It is preferred that all process steps (a) to (d) as well as spooling and vacuum sealing are carried out under clean room conditions (US FED STD 209E cleanroom standards, 1k standard).

The following non-limiting examples illustrate the invention.

Examples

General procedure:

A copper rod of 99.99 wt.-% purity was melted in a vacuum induction furnace and continuously casted into rods of 8 mm in diameter. In further examples small amounts of Cu-10wt.-%Ag or Cu-15wt.-%Pd master alloy were added to the melt to cast Cu-Ag and Cu-Pd alloys, respectively with the following composition:

|  | Composition (wt.-ppm) | |
| --- | --- | --- |
|  | Ag | Pd |
| 99.99 wt.-% pure copper | 12 | 1.2 |
| Cu-Ag alloy | 225 | 0.9 |
| Cu-Pd alloy | 10 | 12490 |

Further, these continuous cast rods were cold wire drawn at room temperature (25 ᵒC). A tungsten carbide die was used to draw heavy wire and a diamond die was used for further reduction. Drawing was performed in four steps at different drawing speeds: heavy wire drawing from 8 mm to 4 mm at 0.5 m/s and 4 mm to 0.8 mm at 1 m/s, intermediate wire drawing from 0.8 mm to 0.16 mm at 4 m/s and fine wire drawing from 0.16 mm to 0.02 mm at 6 m/s. Drawing was supported by making use of a water-based lubricant. The die reduction ratio was 14 % for thick wires (diameter of > 200 $\mu$m) and 8 % for fine wires (diameter of < 200 $\mu$m).

The alloyed Cu-Ag and Cu-Pd wires were intermediate annealed at a diameter of 45 $\mu$m at 400 °C and 600 °C, respectively. The 99.99 wt.-% pure copper wire was not intermediate annealed.

The drawn wires had a final diameter of 20 $\mu$m and exhibited a circumferential copper oxide layer having a layer thickness of 12 nm (average).

The wires were finally strand annealed by running them through a conventional annealing oven and using conventional equipment (including reels, spools, pulleys). Annealing time was 0.3 s. The strand annealing temperature was 600 °C (pure copper), 630 °C (Cu-Ag alloy) and 700 °C (Cu-Pd alloy). The oven was purged with forming gas ($N_2$:$H_2$, 95:5) at a gas exchange rate as shown in Table 2.

Immediately after leaving the oven, i.e. within 0.3 s, the hot wire was quenched in deionized water. Finally, the annealed wire was spooled on a clean anodized (plated) aluminum spool of 50 mm in diameter, vacuum packed and stored.

A typical electro-chemical record measured using SERA of the annealed 99.99 wt.-% pure copper wire showed a reaction potential in the range of -0.4 to -0.6V indicating the existence of a thin $Cu_2O$ layer on the wire surface. CuO and $Cu_2S$ were absent. From the record $Cu_2O$ thickness was calculated to be in the range between 1.7 and 3 nm.

Moreover, ToF-SIMS and XPS revealed free carbon (no evidence of carbide) on the wire surface. ToF-SIMS depth profiling identified the presence of strong carbon earlier to 1 nm deep and further down to zero at a depth of about 5 nm. ToF-SIMS depth profile demonstrated that free carbon was likely to be present on the top of the copper oxide layer, because the free carbon peak was observed to be strong until 1 nm and a strong peak of oxygen and $Cu_2O$ was found after 1 nm.

The wires were tested by ball bonding (1st bond) to Al bond pads and stitch bonding (2nd bond) to silver lead fingers. The free air ball (FAB) was formed under reactive environment by purging with forming gas ($N_2$:$H_2$; 95:5) and it was bonded to Al bond pads attaining strong ball bonding greater than 0.01 g/$\mu$m$^2$ (6.5 g/mil$^2$) and ball pull greater than 8 g.

The following Table 2 shows wire bonding process window results:

Table 2: Ball and stitch bond (1st and 2nd bond) process window

| | 99.99 wt.-% pure copper | | | | | | Cu-Ag alloy | Cu-Pd alloy |
|---|---|---|---|---|---|---|---|---|
| Wire sample | 1 | 2 | 3 | 4 | 5 | 6 | 7 | 8 |
| Ball bond process window (1st bond) | | | | | | | | |
| Purging gas exchange rate (min$^{-1}$) during wire strand annealing | 12.5 | 25 | 37.5 | 50 | 62.5 | 71.2 | 50 | 50 |
| FAB | N.A. | N.A. | N.A. | ++++ | ++ | ++ | ++++ | ++++ |
| USG (mA) | N.A. | N.A. | N.A. | 80-94 | 80-90 | 80-90 | 77-94 | 82-94 |
| Force (g) | N.A. | N.A. | N.A. | 20-27 | 20-27 | 20-27 | 20-27 | 20-27 |
| Window Area (mA·g) | 0 | 0 | 0 | 98 | 70 | 70 | 119 | 84 |
| Stitch bond process window (2nd bond) | | | | | | | | |
| USG, mA | N.A. | N.A. | N.A. | 85-160 | 90-140 | 90-140 | 75-160 | 90-160 |
| Force (g) | N.A. | N.A. | N.A. | 75-140 | 75-140 | 75-140 | 70-140 | 75-140 |
| Window Area (mA·g) | 0 | 0 | 0 | 4875 | 3250 | 3250 | 5950 | 4550 |
| USG = ultrasonic energy ++++Excellent, +++ Very good, ++Good, + Fair | | | | | | | | |

All of the inventive wire samples 4 to 8 resulted in process window which was well suited for industrial application. In particular, inventive wire sample 7 showed values of 119 mA·g and 5950 mA·g for 1st and 2nd bond respectively.

**Claims**

1. A copper wire having a diameter of 10 to 80 $\mu$m, wherein the copper wire bulk material is $\geq$ 99.99 wt.-% pure copper or a copper alloy consisting of 10 to 1000 wt.-ppm of silver and/or of 0.1 to 3 wt.-% of palladium with copper as the remainder to make up 100 wt.-%, **characterized in that** the copper wire has a 0.5 to < 6 nm thin circumferential surface layer of copper oxide.

2. The copper wire of claim 1, **characterized in that** it exhibits a concentration gradient of free carbon over a depth of 0.6 to 5 nm in perpendicular direction from the outer wire surface.

3. The copper wire of any one of the preceding claims, obtainable by a process comprising the steps:

   (a) providing a copper precursor of $\geq$ 99.99 wt.-% pure copper or of the copper alloy,
   (b) drawing the precursor until a final diameter of 10 to 80 $\mu$m of the wire is reached;
   (c) annealing the drawn wire at an object temperature of 570 to 750 °C for 0.2 to 0.4 seconds in a 90 to 96 vol.-% inert gas : 4 to 10 to vol.-% hydrogen atmosphere, and
   (d) quenching the annealed wire in water,

   wherein the vol.-% total 100 vol.-%.

4. The copper wire of claim 3, wherein the copper wire bulk material is $\geq$ 99.99 wt.-% pure copper and the object temperature is in the range of 570 to 630 °C.

5. The copper wire of claim 3, wherein the copper wire bulk material is the copper alloy and the object temperature is in the range of 620 to 750 °C.

**6.** The copper wire of any one of claims 3 to 5,
wherein the volume ratio of inert gas : hydrogen is 95 : 5.

**7.** The copper wire of any one of claims 3 to 6,
wherein the inert gas is nitrogen and/or argon.

**8.** The copper wire of any one of claims 3 to 7,
wherein the annealing is done by pulling the wire through an annealing oven which is purged with the inert gas/hydrogen mixture at a gas exchange rate lying in the range of 43 to 125 min$^{-1}$.

**9.** The copper wire of claim 8,
wherein the gas exchange rate is in the range of 43 to 75 min$^{-1}$, preferably 50 to 63 min$^{-1}$.

**10.** A process for the production of a copper wire of claim 1 or 2 comprising the steps:

(a) providing a copper precursor of $\geq$ 99.99 wt.-% pure copper or of the copper alloy,
(b) drawing the precursor until a final diameter of 10 to 80 $\mu$m of the wire is reached;
(c) annealing the drawn wire at an object temperature of 570 to 750 °C for 0.2 to 0.4 seconds in a 90 to 96 vol.-% inert gas : 4 to 10 to vol.-% hydrogen atmosphere, and
(d) quenching the annealed wire in water,

wherein the vol.-% total 100 vol.-%.

**11.** The process of claim 10,
wherein the copper wire bulk material is $\geq$ 99.99 wt.-% pure copper and the object temperature is in the range of 570 to 630 °C.

**12.** The process of claim 10,
wherein the copper wire bulk material is the copper alloy and the object temperature is in the range of 620 to 750 °C.

**13.** The process of any one of claims 10 to 12,
wherein the volume ratio of inert gas : hydrogen is 95 : 5.

**14.** The process of any one of claims 10 to 13,
wherein the inert gas is nitrogen and/or argon.

**15.** The process of any one of claims 10 to 14,
wherein the annealing is done by pulling the wire through an annealing oven which is purged with the inert gas/hydrogen mixture at a gas exchange rate lying in the range of 43 to 125 min$^{-1}$.

**16.** The process of claim 15,
wherein the gas exchange rate is in the range of 43 to 75 min$^{-1}$, preferably 50 to 63 min$^{-1}$.

**17.** Use of the copper wire according to any one of claims 1 to 9 or made by the process of any one of claims 10 to 16 in wire bonding applications.

**Patentansprüche**

**1.** Kupferdraht, der einen Durchmesser von 10 bis 80 $\mu$m aufweist, wobei es sich bei dem Kupferdrahtgrundmaterial um $\geq$ 99,99 Gewichtsprozent reines Kupfer oder eine Kupferlegierung handelt, die aus 10 bis 1000 Gewichts-ppm Silber und/oder aus 0,1 bis 3 Gewichtsprozent Palladium mit Kupfer als Rest, um 100 Gewichtsprozent zu erhalten, besteht, **dadurch gekennzeichnet, dass** der Kupferdraht eine 0,5 bis < 6 nm dünne Oberflächenschicht aus Kupferoxid in Umfangsrichtung aufweist.

**2.** Kupferdraht nach Anspruch 1, **dadurch gekennzeichnet, dass** er einen Konzentrationsgradienten von freiem Kohlenstoff über eine Tiefe von 0,6 bis 5 nm in rechtwinklig verlaufender Richtung von der Drahtaußenfläche aufweist.

3. Kupferdraht nach einem der vorhergehenden Ansprüche, der durch einen Vorgang gewonnen wird, der folgende Schritte umfasst:

(a) Bereitstellen eines Kupfervorläufers aus ≥ 99,99 Gewichtsprozent reinem Kupfer oder aus der Kupferlegierung,
(b) Ziehen des Vorläufers, bis ein Enddurchmesser von 10 bis 80 μm des Drahts erreicht ist,
(c) Glühen des gezogenen Drahts bei einer Objekttemperatur von 570 bis 750 °C für 0,2 bis 0,4 Sekunden in einer Atmosphäre mit einem Verhältnis von 90 bis 96 Volumenprozent Inertgas : 4 bis 10 Volumenprozent Wasserstoff und
(d) Abkühlen des geglühten Drahts in Wasser,

wobei sich die Volumenprozent zu 100 Volumenprozent addieren.

4. Kupferdraht nach Anspruch 3,
wobei das Kupferdrahtgrundmaterial aus ≥ 99,99 Gewichtsprozent reinem Kupfer besteht und die Objekttemperatur im Bereich von 570 bis 630 °C liegt.

5. Kupferdraht nach Anspruch 3,
wobei das Kupferdrahtgrundmaterial aus der Kupferlegierung besteht und die Objekttemperatur im Bereich von 620 bis 750 °C liegt.

6. Kupferdraht nach einem der Ansprüche 3 bis 5,
wobei das Volumenverhältnis von Inertgas zu Wasserstoff bei 95 : 5 liegt.

7. Kupferdraht nach einem der Ansprüche 3 bis 6,
wobei es sich bei dem Inertgas um Stickstoff und/oder Argon handelt.

8. Kupferdraht nach einem der Ansprüche 3 bis 7,
wobei das Glühen durch Ziehen des Drahts durch einen Glühofen erfolgt, der mit der Inertgas-Wasserstoff-Mischung bei einer Gasaustauschrate, die im Bereich von 43 bis 125 min$^{-1}$ liegt, gespült wird.

9. Kupferdraht nach Anspruch 8,
wobei die Gasaustauschrate im Bereich von 43 bis 75 min$^{-1}$, vorzugsweise von 50 bis 63 min$^{-1}$ liegt.

10. Verfahren für die Herstellung eines Kupferdrahts nach Anspruch 1 oder 2, umfassend folgende Schritte:

(a) Bereitstellen eines Kupfervorläufers aus ≥ 99,99 Gewichtsprozent reinem Kupfer oder aus der Kupferlegierung,
(b) Ziehen des Vorläufers, bis ein Enddurchmesser von 10 bis 80 μm des Drahts erreicht ist,
(c) Glühen des gezogenen Drahts bei einer Objekttemperatur von 570 bis 750 °C für 0,2 bis 0,4 Sekunden in einer Atmosphäre mit einem Verhältnis von 90 bis 96 Volumenprozent Inertgas : 4 bis 10 Volumenprozent Wasserstoff und
(d) Abkühlen des geglühten Drahts in Wasser,

wobei sich die Volumenprozent zu 100 Volumenprozent addieren.

11. Verfahren nach Anspruch 10,
wobei das Kupferdrahtgrundmaterial aus ≥ 99,99 Gewichtsprozent reinem Kupfer besteht und die Objekttemperatur im Bereich von 570 bis 630 °C liegt.

12. Verfahren nach Anspruch 10,
wobei das Kupferdrahtgrundmaterial aus der Kupferlegierung besteht und die Objekttemperatur im Bereich von 620 bis 750 °C liegt.

13. Verfahren nach einem der Ansprüche 10 bis 12,
wobei das Volumenverhältnis von Inertgas zu Wasserstoff bei 95 : 5 liegt.

14. Verfahren nach einem der Ansprüche 10 bis 13,

wobei es sich bei dem Inertgas um Stickstoff und/oder Argon handelt.

**15.** Verfahren nach einem der Ansprüche 10 bis 14,
wobei das Glühen durch Ziehen des Drahts durch einen Glühofen erfolgt, der mit der Inertgas-Wasserstoff-Mischung bei einer Gasaustauschrate, die im Bereich von 43 bis 125 min$^{-1}$ liegt, gespült wird.

**16.** Verfahren nach Anspruch 15,
wobei die Gasaustauschrate im Bereich von 43 bis 75 min$^{-1}$, vorzugsweise von 50 bis 63 min$^{-1}$ liegt.

**17.** Verwendung des Kupferdrahts nach einem der Ansprüche 1 bis 9 oder dessen Herstellung durch das Verfahren nach einem der Ansprüche 10 bis 16 in Bondinganwendungen.

**Revendications**

**1.** Fil de cuivre ayant un diamètre de 10 à 80 $\mu$m, dans lequel le matériau en vrac du fil de cuivre est $\geq$ 99,99 % en poids de cuivre pur ou d'un alliage de cuivre constitué de 10 à 1000 ppm en poids d'argent et/ou de 0,1 à 3 % en poids de palladium avec du cuivre comme le restant pour constituer 100 % en poids, **caractérisé en ce que** le fil de cuivre a une couche superficielle circonférentielle de 0,5 à < 6 nm d'épaisseur d'oxyde de cuivre.

**2.** Fil de cuivre selon la revendication 1, **caractérisé en ce qu'**il présente un gradient de concentration de carbone libre sur une profondeur de 0,6 à 5 nm dans la direction perpendiculaire depuis la surface de fil externe.

**3.** Fil de cuivre selon l'une quelconque des revendications précédentes, pouvant être obtenu par un procédé comprenant les étapes consistant à :

(a) fournir un précurseur de cuivre de $\geq$ 99,99 % en poids de cuivre pur ou de l'alliage de cuivre,
(b) faire revenir le précurseur jusqu'à ce qu'un diamètre final de 10 à 80 $\mu$m du fil soit atteint ;
(c) recuire le fil revenu à une température d'objet de 570 à 750°C pendant 0,2 à 0,4 seconde dans une atmosphère de gaz inerte à 90 à 96 % en volume/hydrogène à 4 à 10 % en volume, et
(d) tremper le fil recuit dans de l'eau,

dans lequel le % en volume totalise 100 % en volume.

**4.** Fil de cuivre selon la revendication 3,
dans lequel le matériau en vrac du fil de cuivre est $\geq$ 99,99 % en poids de cuivre pur et la température d'objet est dans la plage de 570 à 630°C.

**5.** Fil de cuivre selon la revendication 3,
dans lequel le matériau en vrac du fil de cuivre est l'alliage de cuivre et la température d'objet est dans la plage de 620 à 750°C.

**6.** Fil de cuivre selon l'une quelconque des revendications 3 à 5,
dans lequel le rapport volumique de gaz inerte/hydrogène est de 95/5.

**7.** Fil de cuivre selon l'une quelconque des revendications 3 à 6,
dans lequel le gaz inerte est de l'azote et/ou de l'argon.

**8.** Fil de cuivre selon l'une quelconque des revendications 3 à 7,
dans lequel le recuit est réalisé en tirant le fil à travers un four de recuisson qui est purgé avec le mélange de gaz inerte/hydrogène à un taux d'échange gazeux se situant dans la plage de 43 à 125 min$^{-1}$.

**9.** Fil de cuivre selon la revendication 8,
dans lequel le taux d'échange gazeux est dans la plage de 43 à 75 min$^{-1}$, de préférence 50 à 63 min$^{-1}$.

**10.** Procédé de production d'un fil de cuivre selon la revendication 1 ou 2 comprenant les étapes consistant à :

(a) fournir un précurseur de cuivre de $\geq$ 99,99 % en poids de cuivre pur ou de l'alliage de cuivre,

(b) faire revenir le précurseur jusqu'à ce qu'un diamètre final de 10 à 80 μm du fil soit atteint ;

(c) recuire le fil revenu à une température d'objet de 570 à 750°C pendant 0,2 à 0,4 seconde dans une atmosphère de gaz inerte à 90 à 96 % en volume/hydrogène à 4 à 10 % en volume, et

(d) tremper le fil recuit dans de l'eau,

dans lequel le % en volume totalise 100 % en volume.

11. Procédé selon la revendication 10,
dans lequel le matériau en vrac du fil de cuivre est ≥ 99,99 % en poids de cuivre pur et la température d'objet est dans la plage de 570 à 630°C.

12. Procédé selon la revendication 10,
dans lequel le matériau en vrac du fil de cuivre est l'alliage de cuivre et la température d'objet est dans la plage de 620 à 750°C.

13. Procédé selon l'une quelconque des revendications 10 à 12,
dans lequel le rapport volumique de gaz inerte/hydrogène est de 95/5.

14. Procédé selon l'une quelconque des revendications 10 à 13,
dans lequel le gaz inerte est de l'azote et/ou de l'argon.

15. Procédé selon l'une quelconque des revendications 10 à 14,
dans lequel le recuit est réalisé en tirant le fil à travers un four de recuisson qui est purgé avec le mélange de gaz inerte/hydrogène à un taux d'échange gazeux se situant dans la plage de 43 à 125 $min^{-1}$.

16. Procédé selon la revendication 15,
dans lequel le taux d'échange gazeux est dans la plage de 43 à 75 $min^{-1}$, de préférence 50 à 63 $min^{-1}$.

17. Utilisation du fil de cuivre selon l'une quelconque des revendications 1 à 9 ou réalisé par le procédé selon l'une quelconque des revendications 10 à 16 dans des applications de soudure de fils.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Stress-controlled fatigue behaviour of micro-sized polycrystalline copper wires. **B. YANG et al.** MATERIAL SCIENCE AND ENGINEERING A: STRUCTURAL MATERIALS: PROPERTIES, MICROSTRUCTURES AND PROCESSING. ELSEVIER, 25 July 2009, vol. 515, 71-78